# EUROPEAN PATENT APPLICATION

(11) **EP 2 642 840 A2**
(43) Date of publication of application: **25.09.2013**
(21) Application number: 13160644.4
(22) Date of filing: 22.03.2013
(51) Int. Cl.: H05K 5/02

(54) **Mouniting system for component and connector assembly therefore**

(30) Priority: 23.03.2012 GB 201205123
(71) Applicant: Pace Plc, Bradford BD18 3LF (GB)
(72) Inventor: Burns, Gary, Leeds, West Yorkshire BD18 3LF (GB)
(74) Representative: Stephenson, Philip

(57) **Abstract**

The invention relates to apparatus for the location and connection of at least one electrical or electronic component such as a data storage component externally of a housing within which other components are provided and with which the said components operates in connection therewith. The connection is achieved via a connector assembly which has a first part located externally of the housing and a second part located internally of the housing.

## Description

The invention relates to apparatus for supporting and connecting a component with respect to a plurality of further components and/or a housing therefore. In particular, although not necessarily exclusively, the apparatus is provided for the reception and processing of data which is broadcast from one ore more remote locations. The data can then be processed and video, audio and/or auxiliary services generated there from which are made available for user selection and/or storage in memory at the location of the said apparatus. Apparatus of this type is commonly referred to as a Broadcast Data Receiver (BDR) which is apparatus which allows the receipt and/or decoding of data transmitted or broadcast from satellite or cable systems, or terrestrial broadcast systems. In particular, although not necessarily exclusively, the component which is required to be mounted with respect to the apparatus is a component in the form of a PCMCIA (Personal Computer Memory Card Interface Association) card.

As this type of apparatus becomes increasingly popular so there is an increased demand for the apparatus to be provided in as compact a form as possible. This demand typically requires that the required components for operation of the device are located within as small a housing as possible, with the housing defining the external dimensions of the apparatus. A problem with the requirement to reduce the housing size is that the heat generated by the apparatus, and especially by the components within the housing, which are typically connected to one or more printed circuit boards, can be such that the temperature reaches a level that can affect the operation of the components, and to such an extent that the operation of the same cannot be guaranteed to be within required operating parameters. This is unacceptable and so there is a conflict between the need for the housing to be reduced in size as much as possible, whilst maintaining the correct and reliable operation of the components to allow the apparatus to operate correctly.

The aim of the present invention is to provide a means whereby the environment in which at least one of the components is located to operate is improved in terms of allowing the component to operate within an environment such that the reliable operation of the same, and of the apparatus as a whole, can be achieved.

In a first aspect of the invention there is provided electrical and /or electronic apparatus provided to receive and process digital data, said apparatus including a housing defining an interior cavity in which at least one printed circuit board and a plurality of components connected thereto is located and wherein there is provided at least one further component, in communication with the said printed circuit board and/or said plurality of components, said at least one further component located externally of the housing and connected, via a connector assembly which is located internally and externally of the housing, to the at least one printed circuit board and/or plurality of components

Typically said component is located on the underside of the housing when the housing is in it's normal position for use of the apparatus.

In one embodiment the said component is located within a recessed portion of a wall of the housing. Typically the externally mounted part of the connecter assembly is also located in said recess.

In one embodiment the component is located and shielded by the provision of an outer cover. Typically the cover is provided with one or more apertures to allow a cooling effect to be provided to said component in said recess.

In one embodiment the connector assembly includes an external part and an internal part and the external part of the connecting assembly includes means for the mechanical engagement of the component in position. In one embodiment, to achieve the mechanical engagement involves the movement of the component in two directions with regard to the connector assembly. In one embodiment the two directions of movement are such as to allow the component to be moved into an engaged position from a starting point which need not be at the edge of the housing.

Typically the internal and external parts of the connector assembly are connected to each other via a plug and socket arrangement provided at, or adjacent to, the aperture in the housing through which the connector assembly passes.

Typically the internal part of the connector assembly is engaged to a printed circuit board, typically to the underside thereof.

In one embodiment the said component is a PCMCIA card.

The location of this component externally of the housing ensures that the component can be provided in an environment in which the temperature is less then that in the interior of the housing, thereby allowing the component to operate in an acceptable temperature range. Furthermore, the removal of the component from the interior of the housing cavity provides more space and/or allows the size of the housing to be reduced.

Furthermore it removes a component which, itself, generates heat and therefore also allows the environment in the housing interior to have a lower operating temperature range and therefore allow the components therein to operate in an acceptable temperature range.

In a further aspect of the invention there is provided apparatus for the electrical, data and mechanical connection of an electrical or electronic component with respect to data processing apparatus located in a housing, said apparatus including a connector assembly having a first part located externally of the housing and a second part located internally of the housing, said second part is connected to the said data processing means and said first part includes means for the selective connection of the said component so as to allow the connected component to be located externally of the housing and said first and second parts are selectively connectable via a plug and socket arrangement.

In one embodiment the said component located externally of the housing is provided in an environment in which the temperature is less then that in the interior of the housing.

In a further aspect of the invention there is provided a connector assembly to allow connection of at least one data storage component to a plurality of operating components located within a housing, wherein said connector assembly is provided with a first part which is located within and extends from the said housing and allows connection with the said components in said housing and a second part, engageable with the first part, and which second part is located at the exterior of the housing and to which second part, said at least one data storage component is connected to allow the transfer of data between the same and the said operating components.

Typically, the said data storage component is releasably connected to the said second part of the connector assembly.

Typically, the first and second parts of the connector assembly are selectably engagable.

Specific embodiments of the invention are now described with reference to the accompanying drawings wherein;
Figures 1a - d illustrate a plan view of the base of an item of apparatus in accordance with one embodiment of the invention;
Figures 2a - f illustrate the perspective view of the item of apparatus as shown in Figures 1a - d; and
Figures 3a-c illustrate one embodiment of a connector assembly in accordance with the invention and shows a plan view, side view and end elevation respectively.

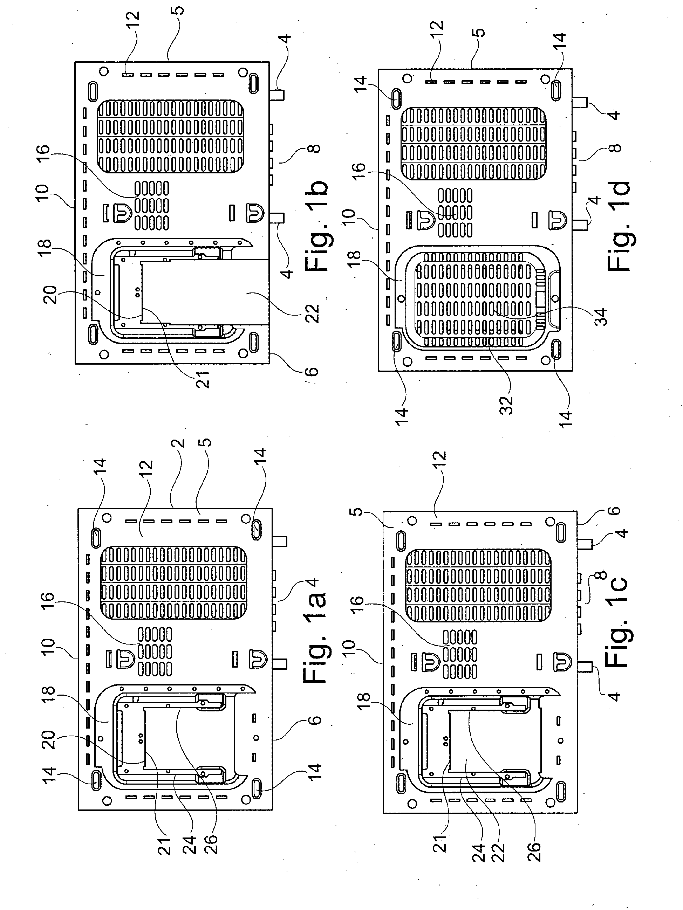

Referring now to the figures 1a-2f, there is illustrated an item of electronic apparatus (2) which, in this case, is a broadcast data receiver provided to receive and process digital data which is broadcast from one or more remote locations. The operation of the apparatus (2) is not of particular importance to the current invention but, typically, the received data enters the receiver via one or more of the connection means (4) on the rear wall (6) of the apparatus housing 5 as shown in Figures 1a - d and then leaves the apparatus via one or more connections (8) to allow the processed digital data representing video, audio and/or ancillary data, to be transmitted to speakers and/or display screens connected thereto.

On the front wall (10) of the apparatus, there is typically provided means for the receipt of infra-red and/or other remote wireless control signals via which a user can interact with, and control, the operation of the BDR, a display means to allow the condition of operation of the apparatus to be indicated to the user and/or manual control buttons.

The top face 11, not shown in detail, of the apparatus, can simply be formed of uniform sheet material or may include ventilation apertures therein.

Figures 1a - d illustrate the underside (12) of the apparatus and show a plurality of feet (14) to allow the underside to be spaced from a support surface so as to allow the flow of air in the gap between the underside 12 and a support surface. The underside also includes a plurality of apertures (16) provided for the purposes of ventilation and cooling and which may be located at, or adjacent to, a fan or other cooling medium provided within the interior of the housing.

It will therefore be appreciated that one of the problems in operation of apparatus of this type is that, firstly, the apparatus is typically operated for many hours at a time, secondly there is a demand for the size of the apparatus to be reduced and, thirdly the components within the interior of the housing generate heat to such an extent that the temperature within the housing can prevent normal operation of the components which are required to provide the service to the user of the apparatus.

In addition to providing a "live" service there is often a need to provide a memory capacity as part of the apparatus and into which memory data representative of user selected programmes or services can be input and stored for subsequent retrieval and use. In addition, or alternatively, data relating to the operation of the apparatus can be stored in the memory and subsequently be retrieved as and when required to allow the operation of the apparatus to be controlled and/or altered.

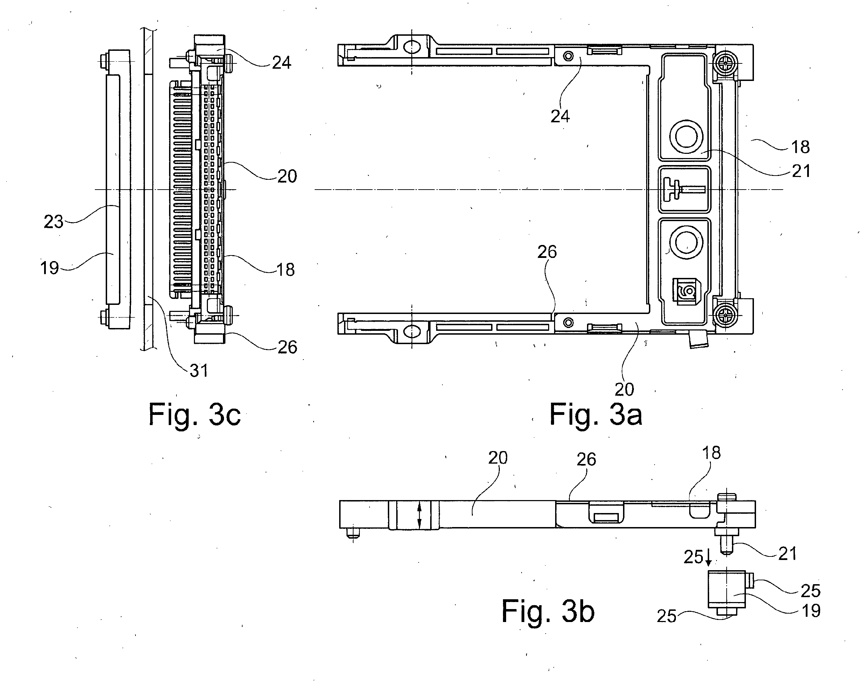

In accordance with the invention, there is provided a connector assembly (18) which is shown in detail in Figures 3a-c. Although it is envisaged that the connector assembly will typically be provided on the underside of the housing it should be appreciated that this need not always be the case and therefore the location of the same on the underside, as shown in the accompanying Figures 1a-2f, is for illustration and is nonlimiting.

The connector assembly 18 comprises a second part 19 located in the interior of the housing and a first part 20 mounted on the exterior of the housing. The interior and exterior parts may be formed as a unitary body but, more typically and as shown, are provided as separate parts which can be selectively engaged during the assembly of the housing and components therefore such that the engagement allows the mechanical and/or electrical and/or data communication between said first and second parts and hence the components connected thereto. As shown in Figures 3b and c this is achieved via the insertion of a male connector 21 provided in the first part 20 in the direction of arrow 25 shown in Figure 3b, into a female connector 23 provided in the second part 19. This is achieved by passing the male connector through an aperture 31 in the housing 5, the wall of part of which is illustrated in cross section in Figure 3c. This therefore allows the connector assembly to pass from externally of the housing via the part 20, through the aperture in the housing and into connection with the second part 19 of the connector assembly.

The second part 19 is typically provided, via an interface 25 provided on the side wall or opposing face from the female connector location, in connection with a printed circuit board or component within the interior of the housing 5 so as to allow the component which is to be connected to the first part 20 of the connector assembly 18 to interact with the components on the printed circuit board in the interior of the housing in a normal manner and as if the same was mounted within the interior of the housing.

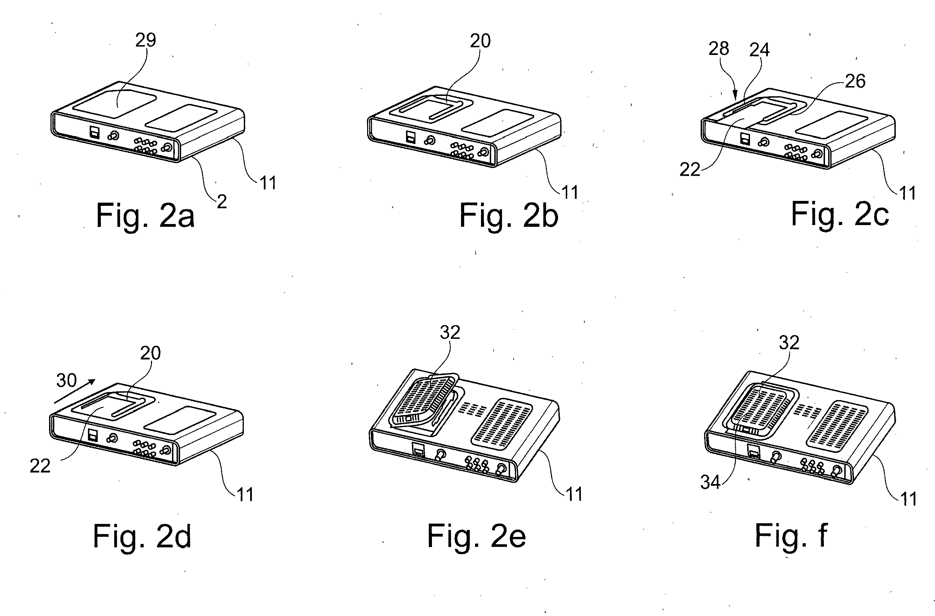

The first part (20) of the connector assembly as indicated above includes the connection means to allow connection to the second part 19 and the transfer of data there between. It also includes a second connecting means (27) which allows connection between the first part 20 and the component (22) which is to be located and mounted therewith. In this case, the component (22) is a memory facility in the form of a PCMCIA card. Also provided in the connector assembly (18), are guide means (24) and (26) which allow the guided movement and engagement of the component (22) into a connecting position. Figures 1a, 2b illustrate the guide means 24,26 and the second connecting means 27 in position. Figures 1b and 2c illustrate the component 22 ready to be moved into position. The guide means (24) and (26) are shaped so as to allow two directions of movement of the component to be performed when moving the component (22) into position. The two directions of movement are typically a first direction of movement indicated by an arrow (28) in Figure 2c and the second direction of movement is indicated by arrow (30) in Figure 2d. The first direction of movement achieves the initial engagement of the component 22 with the guide means (24 and 26) and the second direction of movement moves the component (22) in a guided manner towards engagement with the second connection means 27 of the first part (20) of the connector assembly 18.

By providing the two directions of movement, so the component (22) can be introduced into a position for engagement within the area of a recess 29 on the underside of the housing rather than having to be slid into position from outside of the area of the housing 5. This therefore reduces the amount of space which is required to be provided around the housing in order to engage and disengage the component with and from the connector assembly as the component can be engaged and disengaged with the connector assembly when substantially with the area of the housing 5 which can be important when the apparatus is used in relatively confined space.

Once the component (22) is in an electrically and mechanically engaged position, then, in accordance with this embodiment of the invention, the same is guarded from damage by the fitting of a shield (32) as illustrated in Figures 1d and Figures 2e and f. This shield is provided with a series of apertures (34) as shown so as to allow the component (22) located therein, to be cooled. In a preferred embodiment, the component (22), when connected with the connector assembly, is located in the recessed portion 29 of the underside (12) of the housing such that the external face of the component does not protrude beyond the surface of the underside (12) when it is in position. This allows sufficient space between the underside and the support surface in order to accommodate the provision of the shield (32), if required.

Thus, in accordance with the invention, there is provided a connector assembly which allows the mounting of a component (22) externally of the apparatus housing but still allows the same to be operable in a conventional manner in connection and in communication with, other components of the apparatus which are connected within the housing. The removal of the component from the interior of the housing to the exterior of the housing, allows the temperature within the interior, to be reduced, and also ensures that the component itself can then operate in an environment in which the temperature range is within acceptable limits to ensure the normal operation of said component.

## Claims

1. Electrical and /or electronic apparatus provided to receive and process digital data, said apparatus including a housing defining an interior cavity in which at least one printed circuit board and a plurality of components connected thereto is located and wherein there is provided at least one further component, in communication with the said printed circuit board and/or said plurality of components, said at least one further component located externally of the housing and connected, via a connector assembly which is located internally and externally of the housing, to the at least one printed circuit board and/or plurality of components

2. Apparatus according to claim 1 wherein said component is located on the underside of the housing when the housing is in it's normal position for use.

3. Apparatus according to claim 1 wherein the said component is located within a recessed portion of a wall of the housing.

4. Apparatus according to claim 3 wherein a first part of the connector assembly is also located in said recessed portion.

5. Apparatus according to claim 3 wherein the said component is located and shielded by the provision of a cover.

6. Apparatus according to claim 5 wherein the cover is provided with one or more apertures to allow a cooling effect to be provided to said component in said recessed portion.

7. Apparatus according to claim 1 wherein the connector assembly includes a first part located externally of the housing and a second part located internally of the housing.

8. Apparatus according to claim 7 wherein the first part of the connector assembly includes means for the mechanical and/or electrical and/or data connection of the said component therewith.

9. Apparatus according to claim 8 wherein the connection of the said component involves the movement of the component in two directions with respect to the connector assembly.

10. Apparatus according to claim 9 wherein guide means are provided to guide the movement of the component in the said first and second directions.

11. Apparatus according to claim 7 wherein the said first and second parts of the connector assembly are connected to each other via a plug and socket arrangement.

12. Apparatus according to claim 11 wherein the said plug and socket arrangement is provided at, or adjacent to, the aperture in the housing through which the connector assembly passes.

13. Apparatus according to claim 7 wherein the second part of the connector assembly, which is internal of the housing, is engaged to a printed circuit board located therein.

14. Apparatus according to claim 1 wherein the said component is a Personal Computer Memory Card Interface Association (PCMCIA) card.

15. Apparatus for the electrical, data and mechanical connection of an electrical or electronic component with respect to data processing apparatus located in a housing, said apparatus including a connector assembly having a first part located externally of the housing and a second part located internally of the housing, said second part is connected to the said data processing means and said first part includes means for the selective connection of the said component so as to allow the connected component to be located externally of the housing and said first and second parts are selectively connectable via a plug and socket arrangement.

16. Apparatus according to claim 15 wherein the said component located externally of the housing is provided in an environment in which the temperature is less then that in the interior of the housing.

17. A connector assembly to allow connection of at least one data storage component to a plurality of operating components located within a housing, wherein said connector assembly is provided with a first part which is located within and extends from the said housing and allows connection with the said components in said housing and a second part, engageable with the first part, and which second part is located at the exterior of the housing and to which second part, said at least one data storage component is connected to allow the transfer of data between the same and the said operating components.

18. A connector assembly according to claim 17 wherein the said component is releasably connected to the said second part of the connector assembly.

19. A connector assembly according to claim 17 wherein the first and second parts of the connector assembly are selectably engageable.
